# EUROPEAN PATENT APPLICATION

(11) **EP 4 293 711 A1**
(43) Date of publication of application: **20.12.2023**
(21) Application number: 21958240.0
(22) Date of filing: 16.12.2021
(51) Int. Cl.: H01L 21/762, H01L 27/12

(54) **MANUFACTURING METHOD FOR SEMICONDUCTOR STRUCTURE AND SEMICONDUCTOR STRUCTURE**

(30) Priority: 22.09.2021 CN 202111109636
(71) Applicant: Suzhou Watech Electronics Co., Ltd., Suzhou, Jiangsu 215000 (CN)
(72) Inventor: LI, Rongwei, Suzhou, Jiangsu 215000 (CN)
(74) Representative: Appleyard Lees IP LLP
(86) International application number: PCT/CN2021/138908
(87) International publication number: WO 2023/045129

(57) **Abstract**

The present disclosure provides a method for manufacturing a semiconductor structure and a semiconductor structure. The method includes: providing a first preliminary substrate and a second substrate, the first preliminary substrate including a first base substrate and a groove in the first base substrate; sequentially forming at least a first insulating layer, a trap-rich layer, and a second insulating layer on an exposed surface of the groove to obtain a first substrate; and bonding the first substrate and the second substrate by using a plane where the surfaces of the first base substrate on both sides of the groove are located as a bonding interface to obtain a bonded structure.

## Description

### TECHNICAL FIELD

The present disclosure relates to the semiconductor technologies, and in particular, to a method for manufacturing a semiconductor structure and a semiconductor structure.

### BACKGROUND

In existing technologies, adding a polysilicon trap-rich layer between an oxide layer and silicon of an SOI (Silicon-On-Insulator) wafer can effectively neutralize the negative effects caused by fixed charges in the oxide layer and, to a certain extent, maintain the high-resistance characteristics of the substrate. However, at high temperatures, the polysilicon in contact with the silicon will recrystallize, which reduces the trap-rich layer's ability to trap mobile charges, and impurities between the polysilicon and the high-resistance substrate will diffuse into the substrate, both of which cause the substrate resistance to decrease. The decrease of substrate resistance will increase the loss of radio frequency signals, and the weak mobile charges will cause signal crosstalk between devices.

The above information disclosed in the background is only to enhance the understanding of the background of the technology described in the present disclosure. Therefore, the background may contain certain information that has not formed prior art known to those skilled in the art in the country.

### SUMMARY

According to an aspect of the present disclosure, a method for manufacturing a semiconductor structure is provided. The method includes: providing a first preliminary substrate and a second substrate, the first preliminary substrate including a first substrate and a groove in the first substrate; sequentially forming at least a first insulating layer, a trap-rich layer, and a second insulating layer on an exposed surface of the groove to obtain a first substrate; and bonding the first substrate and the second substrate with a plane where the surfaces of the first base substrate on both sides of the groove are located as a bonding interface to obtain a bonded structure.

In some embodiments, the sequentially forming at least the first insulating layer, the trap-rich layer, and the second insulating layer on the exposed surface of the groove to obtain the first substrate includes: sequentially forming at least the first insulating layer, the trap-rich layer, and the second insulating layer on the exposed surface of the groove to fully fill the groove to obtain the first substrate.

In some embodiments, the second substrate includes a second substrate and a third insulating layer, which are stacked. The sequentially forming at least the first insulating layer, the trap-rich layer, and the second insulating layer on the exposed surface of the groove to obtain the first substrate includes: sequentially forming at least the first insulating layer and the trap-rich layer on the exposed surface of the groove, and forming the second insulating layer in remaining space of the groove and on an exposed surface of the first base substrate to obtain the first substrate. The bonding the first substrate and the second substrate with the plane where the surfaces of the first substrate on both sides of the groove are located as the bonding interface includes: bonding the first substrate and the second substrate with the third insulating layer and the second insulating layer as the bonding interface.

In some embodiments, the forming the second insulating layer in the remaining space of the groove and on the exposed surface of the first base substrate includes: forming a first preliminary insulating layer in the remaining space of the groove and on the exposed surface of the first base substrate; performing a chemical mechanical polishing on the first preliminary insulating layer to remove part of the first preliminary insulating layer to obtain a second preliminary insulating layer; and etching the second preliminary insulating layer to form a plurality of spaced sub-grooves in the second preliminary insulating layer, and the remaining second preliminary insulating layer forming the second insulating layer.

In some embodiments, sequentially forming at least the first insulating layer and the trap-rich layer on the exposed surface of the groove includes: sequentially forming the first insulating layer, the trap-rich layer and a protective layer on the exposed surface of the groove. The sequentially forming the first insulating layer, the trap-rich layer, and the protective layer on the exposed surface of the groove includes: sequentially depositing a first insulating material, a trap-rich material, and a protective material on an exposed surface of the first preliminary substrate; and sequentially removing the protective material and the trap-rich material on the surface of the first base substrate. The remaining protective material forms the protective layer. The remaining trap-rich material forms the trap-rich layer. The remaining first insulating material forms the first insulating layer.

In some embodiments, a material of the protective layer includes silicon nitride.

In some embodiments, materials of the first insulating layer and the second insulating layer respectively includes silicon oxide, and a material of the trap-rich layer includes at least one of polysilicon, SiC, or SiGe.

According to another aspect of the present disclosure, a semiconductor structure is also provided. The semiconductor structure is manufactured by using any one of the methods for manufacturing the semiconductor structure described above.

According to another aspect of the present disclosure, there is also provided a semiconductor structure including a first substrate and a second substrate. The first substrate includes a first base substrate, a groove, a first insulating layer, a trap-rich layer, and a second insulating layer. The groove is defined in the first base substrate. The first insulating layer is located in the groove. The trap-rich layer is located on a surface of the first insulating layer away from an inner wall of the groove. The second insulating layer is located on a surface of the trap-rich layer away from the first insulating layer. The second substrate is located on a surface of the first substrate. The second substrate is bonded to the first substrate, and the bonding interface is a plane where the surfaces of the first base substrate on both sides of the groove are located.

In some embodiments, the second insulating layer fully fills the groove.

In some embodiments, the second substrate includes a second base substrate and a third insulating layer, which are stacked. The second insulating layer fully fills the groove and is located on the surface of the first base substrate. The third insulating layer and the second insulating layer from the bonding interface between the second substrate and the first substrate.

In some embodiments, the first substrate further includes a plurality of sub-grooves, and the sub-grooves are defined in the second insulating layer.

In some embodiments, the first substrate further includes a protective layer, and the protection layer is located between the trap-rich layer and the second insulating layer.

In some embodiments, a thickness of the first insulating layer ranges from 0.5nm to 10nm.

### BRIEF DESCRIPTION OF THE DRAWINGS

The accompanying drawings constituting a part of the present disclosure are used to provide a further understanding of the present disclosure, and the exemplary embodiments and descriptions of the present disclosure are used to explain the present disclosure, and do not constitute improper limitations to the present disclosure. In the attached figures:
FIG. 1 shows a flowchart of a method for manufacturing a semiconductor structure according to some embodiments of the present disclosure;
FIG. 2 to FIG. 9 respectively show schematic diagrams of semiconductor structures formed in process steps of a method for manufacturing a semiconductor structure according to some embodiments of the present disclosure;
FIG. 10 shows a schematic structural diagram of a high-frequency device made of a semiconductor structure according to some embodiments of the present disclosure.

### DETAILED DESCRIPTION OF THE EMBODIMENTS

It should be noted that the following detailed description is exemplary and intended to provide further explanation of the present disclosure. Unless otherwise defined, all technical and scientific terms used herein have the same meaning as commonly understood by one of ordinary skill in the art to which the present disclosure belongs.

It should be noted that the terms used herein are merely for describing specific embodiments, and are not intended to limit the exemplary embodiments according to the present disclosure. As used herein, unless the context clearly dictates, singular forms are also intended to include plural forms. It should also be understood that when the terms "include" and/or "comprise" are used herein, they indicate the presence of features, steps, operations, devices, components and/or combinations thereof.

It should be understood that when an element (such as a layer, a film, a region, or a substrate) is referred to as being "on" another element, it can be directly located on the other element, or intervening elements may also be present. In addition, in the specification and claims, when an element is referred to as being "connected" to another element, the element may be "directly connected" to the other element or "connected" to the other element through a third element.

As described in the background, the main purpose of the present disclosure is to provide a method for manufacturing a semiconductor structure and a semiconductor structure to solve the problem of large losses of radio frequency signals and signal crosstalk caused by adding a trap-rich layer between an oxide layer and silicon in an SOI wafer in the prior art.

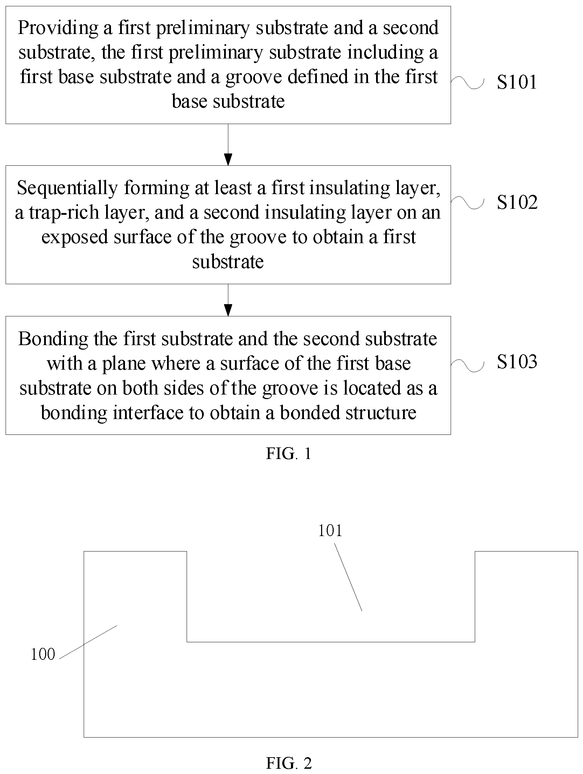

A method for manufacturing a semiconductor structure is provided according to a typical embodiment of the present disclosure. FIG. 1 is a flowchart of a method for manufacturing a semiconductor structure according to some embodiments of the present disclosure. As shown in FIG. 1, the method for manufacturing the semiconductor structure includes the following steps.

In step S101, a first preliminary substrate and a second substrate are provided, and the first preliminary substrate includes a first base substrate 100 and a groove 101 defined in the first base substrate 100, as shown in FIG. 2.

In step S102, at least a first insulating layer 102, a trap-rich layer 103, and a second insulating layer 104 are sequentially formed on an exposed surface of the groove 101 to obtain a first substrate.

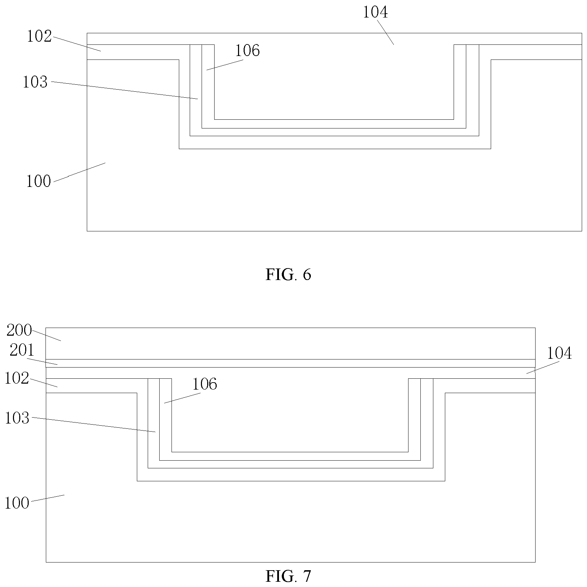

In step S103, the first substrate and the second substrate are bonded with a plane where the surfaces of the first base substrate 100 on both sides of the groove 101 are located as a bonding interface to obtain a bonded structure shown in FIG. 7, FIG. 8, or FIG. 9.

In the above method for manufacturing the semiconductor structure, a first preliminary substrate including a first base substrate and a groove, and a second substrate are first provided. Then, at least a first insulating layer, a trap-rich layer, and a second insulating layer are sequentially formed on the exposed surface of the groove to obtain a first substrate. Finally, the first substrate and the second substrate are bonded with a plane where the surfaces of the first base substrate on both sides of the groove are located as a bonding interface. According to the method for manufacturing the semiconductor structure, the trap-rich layer and the first base substrate are isolated by the first insulating layer such that the trap-rich layer does not directly contact the first base substrate, ensuring that the trap-rich layer will substantially not recrystallize at high temperatures, thereby ensuring the stability of the high-resistance performance the device. In addition, the trap-rich layer suppresses the formation of a weak mobile charge accumulation region between the trapped charges in the second insulating layer and the shallow layer region of the interface of the first base substrate, effectively suppressing the negative effects caused by the trapped charge in the second insulating layer and ensuring low device loss and low signal crosstalk between devices. Therefore, the problems of large losses of radio frequency signals and signal crosstalk caused by adding a trap-rich layer between the oxide layer and silicon of the SOI wafer in the prior art are solved.

The first insulating layer in the present disclosure may be formed by dry oxide growth or wet oxide growth. The formed first insulating layer can separate the subsequently grown trap-rich layer from the first base substrate, thereby preventing the recrystallization of the trap-rich layer at high temperatures. The thermally grown first insulating layer does not need to be too thick. The thickness of the first insulating layer ranges from 0.5nm to 10nm, so that the charges that cause power consumption and signal interference can pass through the first insulating layer and be captured by the trap-rich layer. The trap-rich layer may be a polysilicon layer. The polysilicon layer is obtained by depositing an amorphous silicon material layer on the first insulating layer and then performing thermal annealing on the amorphous silicon material layer. Polysilicon has a large number of interface states, which perform as carrier traps that can capture carriers, thus preventing the carriers from causing substrate crosstalk. In addition to polysilicon, the trap-rich layer may also be made of materials such as SiC or SiGe.

In a practical application, the region of the groove can be determined according to the needs of the actual device or circuit. In this region, photoresist is deposited, developed, and then etched to form the groove. The etching method may be dry etching, wet etching, or a combination of dry etching and wet etching. The depth of the groove is determined according to the requirements of the device or circuit design and typically ranges from 200nm to 2µm. In a specific embodiment, the groove can be etched with a large aspect ratio to further reduce parasitic capacitance. The first insulating layer, the trap-rich layer, and the second insulating layer are filled in the groove to form a cavity structure.

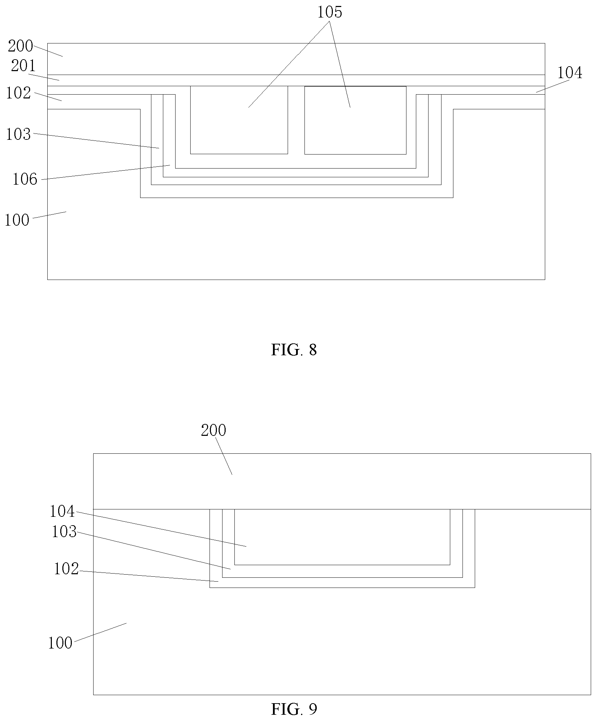

In order to further ensure a small parasitic power loss as well as small harmonic disturbance of the semiconductor structure under high-frequency applications, in a specific embodiment of the present disclosure, a high-resistance substrate is selected to be the first base substrate. The first base substrate is a silicon substrate. The first insulating layer is a silicon oxide layer. The second insulating layer is a silicon oxide layer. The trap-rich layer is a polysilicon layer. The second substrate is a second base substrate. A high-resistance substrate may be selected to be the second base substrate. The second base substrate is a silicon substrate. The bonded structure between the first substrate and the second substrate as shown in FIG. 9 is formed through silicon-silicon interface bonding.

In order to ensure that the process of obtaining the first substrate is relatively simple, according to another specific embodiment of the present disclosure, as shown in FIG. 2 and FIG. 9, sequentially forming at least the first insulating layer, the trap-rich layer, and the second insulating layer on the exposed surface of the groove to obtain the first substrate includes: sequentially forming at least the first insulating layer 102, the trap-rich layer 103, and the second insulating layer 104 on the exposed surface of the groove 101 to full fill the groove 101 to obtain the first substrate. In this way, it is further ensured that the trap-rich layer will substantially not recrystallize at high temperatures, thereby further ensuring the stability of the device in high temperature environments. In addition, it further ensures a small device loss and a small signal crosstalk between devices.

According to a specific embodiment of the present disclosure, sequentially forming at least the first insulating layer 102, the trap-rich layer 103, and the second insulating layer 104 on the exposed surface of the groove 101 to full fill the groove 101 to obtain the first substrate includes: sequentially depositing a first insulating material, a trap-rich material, a protective material, and a second insulating material on an exposed surface of the first preliminary substrate to full fill the groove; removing part of the second insulating material, the protective material, the trap-rich material, and the first insulating material to expose the surface of the first base substrate, such that the remaining second insulating material forms the second insulating layer, the remaining protective material forms a protective layer, the remaining trap-rich material forms the trap-rich layer, and the remaining first insulating material forms the first insulating layer.

In a practical application, according to yet another specific embodiment of the present disclosure, as shown in FIG. 7, the second substrate includes a second base substrate and a third insulating layer, which are stacked. Sequentially forming at least the first insulating layer, the trap-rich layer, and the second insulating layer on the exposed surface of the groove to obtain the first substrate includes: sequentially forming at least the first insulating layer 102 and the trap-rich layer 103 on the exposed surface of the groove; forming the second insulating layer 104 in the remaining space of the groove and on the exposed surface of the first base substrate to obtain the first substrate as shown in FIG.6. Bonding the first substrate and the second substrate with the plane where the surfaces of the first base substrate on both sides of the groove are located as the bonding interface includes bonding the first substrate and the second substrate with the third insulating layer 201 and the second insulating layer 104 as the bonding interface to obtain the bonded structure as shown in FIG. 7.

In a practical application, the process of forming the second substrate includes providing a second base substrate, forming a third preliminary insulating layer on the exposed surface of the second base substrate, and planarizing the third preliminary insulating layer using a physical or combined physicochemical method such that the thickness of the remaining third preliminary insulating layer is in the range of 1nm to 50nm to obtain the third insulating layer. The third preliminary insulating layer may be formed by dry oxide growth, wet oxide growth, or other feasible methods in the prior art.

Specifically, both the third insulating layer and the second insulating layer are silicon dioxide layers, and the above process realizes silicon dioxide-silicon dioxide bonding between the first substrate and the second substrate.

In order to further ensure a small parasitic capacitance of the obtained bonded structure and thus further ensure better device performance, according to another specific embodiment of the present disclosure, forming the second insulating layer 104 in the remaining space of the groove and on the exposed surface of the first base substrate includes: forming a first preliminary insulating layer in the remaining space of the groove and on the exposed surface of the first base substrate; performing a chemical mechanical polishing on the first preliminary insulating layer to remove part of the first preliminary insulating layer to obtain a second preliminary insulating layer; etching the second preliminary insulating layer to form a plurality of spaced sub-grooves 105 in the second preliminary insulating layer as shown in FIG. 8, and the remaining second preliminary insulating layer forming the second insulating layer 104. Forming the sub-grooves causes a plurality of cavity structures to be formed in the bonded structure formed by bonding the first substrate and the second substrate. The plurality of cavity structures ensure that the device has a low thermal resistance and a low parasitic capacitance. Moreover, the sub-grooves will not expose the trap-rich layer. In the above-mentioned method, a plurality of cavity regions are formed without exposing the trap-rich layer, further ensuring that the parasitic capacitance of the device is small. In addition, the fourth insulating layer between the cavities forms supporting pillars, further ensuring the stability of the cavity structure.

It should be noted that the process of obtaining the second preliminary insulating layer is not limited to the above-mentioned chemical mechanical polishing, and may also be a physical or a combination of physical and chemical methods of polishing.

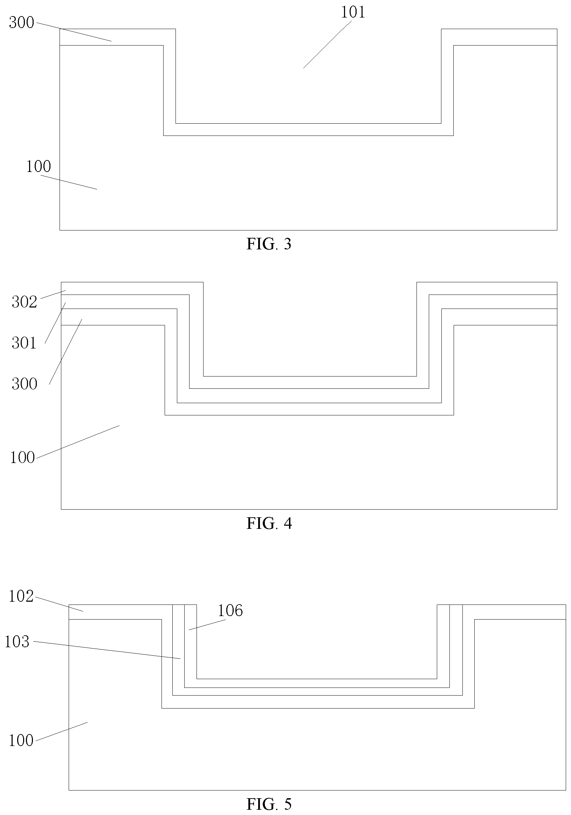

According to yet another specific embodiment of the present disclosure, sequentially forming at least the first insulating layer and the trap-rich layer on the exposed surface of the groove includes sequentially forming the first insulating layer, the trap-rich layer, and a protective layer on the exposed surface of the groove. Sequentially forming the first insulating layer, the trap-rich layer, and the protective layer on the exposed surface of the groove includes, as shown in FIG. 2 to FIG. 5, sequentially depositing a first insulating material 300 (as shown in FIG. 3), a trap-rich material 301, and a protective material 302 on the exposed surface of the first preliminary substrate to obtain a structure shown in FIG. 4, and sequentially removing the protective material 302 and the trap-rich material 301 on the surface of the first base substrate 100. The remaining protective material 302 forms the protective layer 106, the remaining trap-rich material 301 forms the trap-rich layer 103, and the remaining first insulating material 300 forms the first insulating layer 102, thus the structure shown in FIG. 5 is obtained. By growing a protective layer on the surface of the trap-rich layer, it is ensured that the trap-rich layer will not be damaged in subsequent processes, thereby further ensuring better performance of the device. Of course, if there is no subsequent process that seriously affects the trap-rich layer, the growth of the protective layer may not be performed. It should be noted that the removal process can remove part or all of the first insulating material on the surface of the first base substrate. Those skilled in the art can flexibly choose whether to retain the first insulating material on the surface of the first base substrate according to the actual situation.

In a practical application, the material of the protective layer may be a feasible material in the prior art. In a specific embodiment, the material of the protective layer includes silicon nitride. In a more specific embodiment, the material of the protective layer is silicon nitride. The materials of the above-mentioned structural layers may all be feasible materials in the prior art. According to another specific embodiment of the present disclosure, the material of the first insulating layer and the material of the second insulating layer each include silicon oxide. The material of the trap-rich layer includes at least one of polysilicon, SiC, or SiGe. According to another more specific embodiment of the present disclosure, the material of the first insulating layer and the material of the second insulating layer are respectively silicon oxide, and the material of the trap-rich layer is at least one of polysilicon, SiC, or SiGe.

In yet another specific embodiment of the present disclosure, after bonding the first substrate and the second substrate to obtain the bonded structure, the method further includes thinning the bonded structure.

It should be noted that each step, especially the bonding step, in the above method needs to be carried out in an ultra-cleanroom to ensure that impurities are not introduced at the interface during bonding.

The above-mentioned structural layers are formed by one or more of molecular beam epitaxy (MBE), metal organic chemical vapor deposition (MOCVD), metal organic vapor phase epitaxy (MOVPE), hydride vapor phase epitaxy (HVPE), and/or other known crystal growth processes.

According to another typical embodiment of the present disclosure, a semiconductor structure is provided. The semiconductor structure is manufactured by using any one of the above methods for manufacturing semiconductor structure.

The semiconductor structure is obtained by using any one of the above-mentioned methods for manufacturing semiconductor structure. According to the method, the trap-rich layer and the first base substrate are isolated by the first insulating layer such that the trap-rich layer does not directly contact the first base substrate, ensuring that the trap-rich layer will substantially not recrystallize at high temperatures, thereby ensuring that the high-resistance performance of the obtained semiconductor structure is more stable. In addition, the trap-rich layer suppresses the formation of a weak mobile charge accumulation region between the trapped charges in the second insulating layer and the shallow layer region of the interface of the first substrate, effectively suppressing the negative effects caused by the trapped charges in the second insulating layer, and ensuring that the loss of the semiconductor structure is low and the signal crosstalk between the semiconductor structures is small. Therefore, the problems of large losses of radio frequency signals and signal crosstalk caused by adding the trap-rich layer between the oxide layer and silicon of the SOI wafer in the prior art are solved.

According to yet another typical embodiment of the present disclosure, there is provided a semiconductor structure as shown in FIG. 7, FIG. 8, and FIG. 9, including a first substrate and a second substrate. The first substrate includes a first base substrate, a groove, a first insulating layer, a trap-rich layer, and a second insulating layer. The groove is defined in the first base substrate. The first insulating layer is in the groove. The trap-rich layer is located on the surface of the first insulating layer away from the inner wall of the groove. The second insulating layer is located on the surface of the trap-rich layer away from the first insulating layer. The second substrate is located on the surface of the first substrate. The second substrate and the first substrate are bonded, and the bonding interface is the plane where the surfaces of the first base substrate on both sides of the groove are located.

The semiconductor structure includes a first substrate and a second substrate. The first substrate includes a first base substrate, a groove, a first insulating layer, a trap-rich layer, and a second insulating layer. The second substrate and the first substrate are bonded, and the bonding interface is the plane where the surfaces of the first base substrate on both sides of the groove are located. In the semiconductor structure, the trap-rich layer and the first base substrate are isolated by the first insulating layer such that the trap-rich layer does not directly contact the first substrate, ensuring that the trap-rich layer will substantially not recrystallize at high temperatures, thereby ensuring the stability of the high-resistance performance of the device. In addition, the trap-rich layer suppresses the formation of a weak mobile charge accumulation region between the trapped charges in the second insulating layer and the shallow layer region of the interface of the first substrate, effectively suppressing the negative effects caused by the trapped charge in the second insulating layer, ensuring low loss of the device and small signal crosstalk between devices. Therefore, the problems of large losses of radio frequency signals and signal crosstalk caused by adding a trap-rich layer between the oxide layer and silicon of the SOI wafer in the prior art are solved.

In order to further ensure the stability of the semiconductor structure, in a specific embodiment, as shown in FIG. 7 and FIG. 9, the second insulating layer 104 fully fills the groove.

According to another specific embodiment of the present disclosure, the second substrate includes a second base substrate and a third insulating layer, which are stacked. The second insulating layer fully fills the groove and is also located on the surface of the first base substrate. The third insulating layer and the second insulating layer form the bonding interface between the second substrate and the first substrate.

In order to further ensure that the parasitic capacitance of the bonded structure is small and thus further ensure a better performance of the device, according to another specific embodiment of the present disclosure, as shown in FIG. 8, the first substrate further includes a plurality of sub-grooves 105. The sub-grooves 105 are defined in the second insulating layer 104. A plurality of cavity regions are formed in the semiconductor structure without exposing the trap-rich layer, further ensuring that the parasitic capacitance of the device is small. In addition, a fourth insulating layer between the cavities forms supporting pillars, further ensuring the stability of the cavity structure.

In order to further avoid damage to the trap-rich layer in subsequent processes, in a specific embodiment, the first substrate further includes a protective layer 106. The protective layer 106 is between the trap-rich layer 103 and the second insulating layer 104. By growing a protective layer on the surface of the trap-rich layer, it is ensured that the trap-rich layer will not be damaged in subsequent processes, thereby further ensuring better performance of the device. Of course, if there is no subsequent process that seriously affects the trap-rich layer, the growth of the protective layer may not be performed.

According to another specific embodiment of the present disclosure, a high-resistance silicon substrate may be selected to be the first base substrate. The first insulating layer is a silicon oxide layer. The second insulating layer is a silicon oxide layer. The third insulating layer is a silicon oxide layer. The trap-rich layer is a polysilicon layer. The second base substrate is a high-resistance silicon substrate, and the protective layer is a silicon nitride layer.

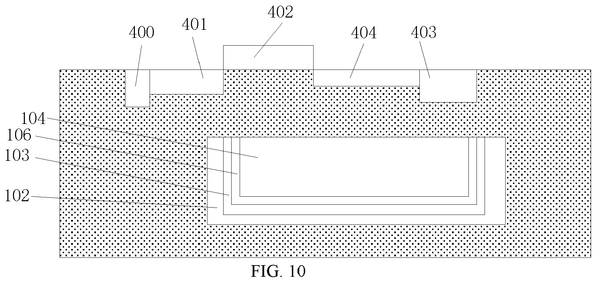

In a specific embodiment, the semiconductor structure can be applied to the design and manufacture of high-frequency devices. As shown in FIG. 10, a back electrode 400, a source electrode 401, a gate electrode 402, and a drain electrode 403 are formed in the bonded structure of the present disclosure. A drift region 404 is formed between the gate electrode 402 and the drain electrode 403. According to the needs of the device, the cavity formed by the insulating layer 102, the trap-rich layer 103, the protective layer 106, and the second insulating layer 104 is arranged under the drift region 404 and the drain electrode 403. Due to the existence of the cavity under the drift region and the drain electrode, the junction of the lightly doped drain structure of the laterally diffused metal oxide semiconductor reaches the oxide layer on the cavity wall, reducing the source-drain capacitance and parasitic capacitance, thereby significantly reducing the total output capacitance of the circuit, and improving the high-frequency performance and efficiency of the laterally diffused metal oxide semiconductor.

From the above description, it can be seen that the above-mentioned embodiments of the present disclosure achieve the following technical effects.

1) In the method for manufacturing the semiconductor structure of the present disclosure, a first preliminary substrate including a first base substrate and a groove, and a second substrate are firstly provided. Then, at least a first insulating layer, a trap-rich layer, and a second insulating layer are sequentially formed on the exposed surface of the groove to obtain a first substrate. Finally, the first substrate and the second substrate are bonded with the plane where the surfaces of the first base substrate on both sides of the groove are located as a bonding interface. According to the method for manufacturing the semiconductor structure, the trap-rich layer and the first base substrate are isolated by the first insulating layer such that the trap-rich layer does not directly contact the first base substrate, ensuring that the trap-rich layer will substantially not recrystallize at high temperatures, thereby ensuring the stability of the high-resistance performance of the device. In addition, the trap-rich layer suppresses the formation of a weak mobile charge accumulation region between the trapped charges in the second insulating layer and the shallow layer region of the interface of the first substrate, effectively suppressing the negative effects of the trapped charge in the second insulating layer, and ensuring low device loss and low signal crosstalk between devices. The problems of large losses of radio frequency signals and signal crosstalk caused by adding the trap-rich layer between the oxide layer and silicon of the SOI wafer in the prior art are solved.

2) The semiconductor structure in the present disclosure is manufactured by using any one of the above-mentioned methods for manufacturing the semiconductor structure. According to the method, the trap-rich layer and the first substrate are isolated by the first insulating layer such that the trap-rich layer does not directly contact the first base substrate, ensuring that the trap-rich layer will substantially not recrystallize at high temperatures, thereby ensuring that the high-resistance performance of the obtained semiconductor structure is more stable. In addition, the trap-rich layer suppresses the formation of a weak mobile charge accumulation region between the trapped charges in the second insulating layer and the shallow layer region of the interface of the first substrate, effectively suppressing the negative effects of the trapped charges in the second insulating layer, and ensuring low loss of the semiconductor structure and small signal crosstalk between the semiconductor structures. The problems of large losses of radio frequency signals and signal crosstalk caused by adding the trap-rich layer between the oxide layer and silicon of the SOI wafer in the prior art are solved.

3) The semiconductor structure in the present disclosure includes a first substrate and a second substrate. The first substrate includes a first base substrate, a groove, a first insulating layer, a trap-rich layer, and a second insulating layer. The second substrate and the first substrate are bonded, and the bonding interface is the plane where the surfaces of the first base substrate on both sides of the groove are located. In the semiconductor structure, the trap-rich layer and the first substrate are isolated by the first insulating layer, so that the trap-rich layer does not directly contact the first substrate, ensuring that the trap-rich layer will substantially not recrystallize at high temperatures, thereby ensuring the stability of the high-resistance performance of the device. In addition, the trap-rich layer suppresses the formation of a weak mobile charge accumulation region between the trapped charges in the second insulating layer and the shallow layer region of the interface of the first substrate, effectively suppressing the negative effects caused by the trapped charge in the second insulating layer, and ensuring low device loss and small signal crosstalk between devices. The problems of large losses of radio frequency signals and signal crosstalk caused by adding the trap-rich layer between the oxide layer and silicon of the SOI wafer in the prior art are solved.

## Claims

1. A method for manufacturing a semiconductor structure, comprising:
providing a first preliminary substrate and a second substrate, the first preliminary substrate comprising a first base substrate (100) and a groove (101) defined in the first base substrate (100);
sequentially forming at least a first insulating layer (102), a trap-rich layer (103), and a second insulating layer (104) on an exposed surface of the groove (101) to obtain a first substrate; and
bonding the first substrate and the second substrate with a plane where surfaces of the first base substrate (100) on both sides of the groove (101) are located as a bonding interface to obtain a bonded structure.

2. The method according to claim 1, wherein the sequentially forming at least the first insulating layer (102), the trap-rich layer (103), and the second insulating layer (104) on the exposed surface of the groove (101) to obtain the first substrate comprises:
sequentially forming at least the first insulating layer (102), the trap-rich layer (103), and the second insulating layer (104) on the exposed surface of the groove (101) to fully fill the groove (101) to obtain the first substrate.

3. The method according to claim 1, wherein the second substrate comprises a second base substrate (200) and a third insulating layer (201), which are stacked,
the sequentially forming at least the first insulating layer (102), the trap-rich layer (103), and the second insulating layer (104) on the exposed surface of the groove (101) to obtain the first substrate, comprising:
sequentially forming at least the first insulating layer (102) and the trap-rich layer (103) on the exposed surface of the groove (101); and
forming the second insulating layer (104) in a remaining space of the groove (101) and on an exposed surface of the first base substrate (100) to obtain the first substrate;
the bonding the first substrate and the second substrate with the plane where the surfaces of the first base substrate (100) on both sides of the groove (101) are located as the bonding interface, comprising:
bonding the first substrate and the second substrate with the third insulating layer (201) and the second insulating layer (104) as the bonding interface.

4. The method according to claim 3, wherein the forming the second insulating layer (104) in the remaining space of the groove (101) and on the exposed surface of the first base substrate (100) comprises:
forming a first preliminary insulating layer in the remaining space of the groove (101) and on the exposed surface of the first base substrate (100);
performing a chemical mechanical polishing on the first preliminary insulating layer to remove part of the first preliminary insulating layer to obtain a second preliminary insulating layer; and
etching the second preliminary insulating layer to form a plurality of spaced sub-grooves (105) in the second preliminary insulating layer, and the remaining second preliminary insulating layer forming the second insulating layer (104).

5. The method according to claim 3, wherein the sequentially forming at least the first insulating layer (102) and the trap-rich layer (103) on the exposed surface of the groove (101) comprises:
sequentially forming the first insulating layer (102), the trap-rich layer (103), and a protective layer (106) on the exposed surface of the groove (101),
wherein the sequentially forming the first insulating layer (102), the trap-rich layer (103), and the protection layer (106) on the exposed surface of the groove (101) comprises:
sequentially depositing a first insulating material (300), a trap-rich material (301), and a protective material (302) on an exposed surface of the first preliminary substrate; and
sequentially removing the protective material (302) and the trap-rich material (301) on the surface of the first base substrate (100), wherein the remaining protective material (302) forms the protective layer (106), the remaining trap-rich material (301) forms the trap-rich layer (103), and the remaining first insulating material (300) forms the first insulating layer (102).

6. The method according to claim 5, wherein a material of the protective layer (106) comprises silicon nitride.

7. The method according to any one of claims 1 to 4, wherein materials of the first insulating layer (102) and the second insulating layer (104) respectively comprise silicon oxide, and a material of the trap-rich layer (103) comprises at least one of polysilicon, SiC, or SiGe.

8. A semiconductor structure, wherein the semiconductor structure is manufactured by the method according to any one of claims 1 to 7.

9. A semiconductor structure, comprising:
a first substrate comprising a first base substrate (100), a groove (101), a first insulating layer (102), a trap-rich layer (103), and a second insulating layer (104), wherein the groove (101) is defined in the first base substrate (100), the first insulating layer (102) is located in the groove (101), the trap-rich layer (103) is located on a surface of the first insulating layer (102) away from an inner wall of the groove (101), and the second insulating layer (104) is located on a surface of the trap-rich layer (103) away from the first insulating layer (102); and
a second substrate located on a surface of the first substrate, the second substrate being bonded to the first substrate, and the bonding interface being a plane where surfaces of the first base substrate (100) on both sides of the groove (101) are located.

10. The semiconductor structure according to claim 9, wherein the second insulating layer (104) fully fills the groove (101).

11. The semiconductor structure according to claim 9, wherein the second substrate comprises a second base substrate (200) and a third insulating layer (201) which are stacked, the second insulating layer (104) fully fills the groove (101) and is located on the surface of the first base substrate (100), and the third insulating layer (201) and the second insulating layer (104) form the bonding interface between the second substrate and the first substrate.

12. The semiconductor structure according to claim 11, wherein the first substrate further comprises a plurality of sub-grooves (105), the sub-grooves (105) being defined in the second insulating layer (104).

13. The semiconductor structure according to claim 10 or 11, wherein the first substrate further comprises a protective layer (106), the protective layer (106) being located between the trap-rich layer (103) and the second insulating layer (104).

14. The semiconductor structure according to claim 9, wherein a thickness of the first insulating layer (102) ranges from 0.5nm to 10nm.
